# EUROPEAN PATENT APPLICATION

(11) **EP 2 328 268 A1**
(43) Date of publication of application: **01.06.2011**
(21) Application number: 09814550.1
(22) Date of filing: 14.09.2009
(51) Int. Cl.: H02P 29/00, B62D 5/04, B62D 6/00, B62D 101/00, B62D 119/00

(54) **MOTOR CONTROLLER AND ELECTRIC POWER STEERING DEVICE**

(30) Priority: 17.09.2008 JP 2008238220
(71) Applicant: JTEKT Corporation, Osaka-shi, Osaka 542-8502 (JP)
(72) Inventor: SAKAI, Atsuo, Osaka-shi Osaka 542-8502 (JP)
(74) Representative: TBK
(86) International application number: PCT/JP2009/066010
(87) International publication number: WO 2010/032705

(57) **Abstract**

A microcomputer 17 detects and determines whether a problem exists in a power supply breaker of an ECU 11 functioning as a motor controller. Specifically, the microcomputer 17 determines whether there is a malfunction caused by a short circuit in a first FET 26 based on the output voltage V1 and output voltage V2 that are detected in a first FET 26 and a second FET 27, respectively, when the switching states of the first and second FETs 26, 27 are both off. Afterwards, the microcomputer 17 determines whether there is a malfunction caused by a break in the first FET 26 based on the output voltages V1, V2 of the first and second FETs 26, 27 that are detected when only the first FET 26 is switched on. If the microcomputer 17 determines that the first FET 26 is free from any malfunction, the microcomputer 17 determines whether there is a malfunction caused by a short circuit or a break in the second FET 27 by comparing the output voltage V1 of the first FET 26 and a charge voltage Vc of a smoothing capacitor 22 that are detected afterwards.

## Description

### TECHNICAL FIELD

The present invention relates to a motor controller and an electric power steering device.

### BACKGROUND ART

Many motor controllers include a power supply breaker (power supply breaking means) that is arranged in a power supply line connecting a power supply to a driver circuit and interrupts the power supply line. A conventional power supply breaker is configured by a relay circuit, or, in other words, a power supply relay, which uses a mechanical relay in which a contact is selectively turned on and off by supply of the power to a coil mounted in the power supply breaker (see, for example, Patent Document 1). A problem is detected (determined) in the power supply relay typically by monitoring change in the output voltage from the power supply relay when the power supply is turned on.

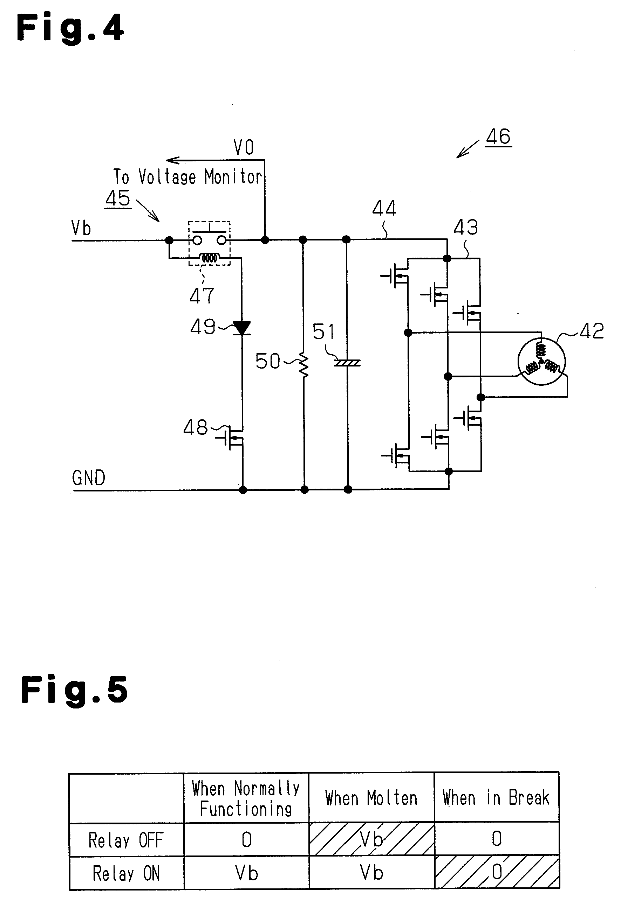

Specifically, in a motor controller 46 illustrated in Fig. 4, for example, a motor 42 receives drive power based on power supply voltage Vb from a driver circuit 43. A power supply and the driver circuit 43 are connected to each other through a power supply line 44. A power supply relay 45 is arranged in the power supply line 44. Determination of a problem in the power supply relay 45, or, more specifically, melting and breaking of a mechanical relay 47 of the power supply relay 45, is carried out according to the procedure described below.

That is, as represented in Fig. 5, as long as the power supply relay 45 functions normally, it is assumed that the output voltage V0 of the power supply relay 45 is equal to the power supply voltage Vb only when the power supply relay 45 is on. Accordingly, if the output voltage V0 of the power supply relay 45 is equal to the power supply voltage Vb in spite of the fact that the power supply relay 45 is off, it can be determined that the mechanical relay 47 malfunctions due to melting of the mechanical relay 47. When the output voltage V0 of the power supply relay 45 is not equal to the power supply voltage Vb in spite of the fact that the power supply relay 45 is on, it can be determined that the mechanical relay 47 malfunctions due to a break of the mechanical relay 47.

The power supply relay 45 of the motor controller 46 includes an FET 48, which selectively permits and stops supply of the power to a relay coil of the mechanical relay 47, and a diode 49, in addition to the mechanical relay 47. A pull-down resistor 50 and a smoothing capacitor 51 are arranged between the power supply relay 45 and the driver circuit 43. The pull-down resistor 50 detects the output voltage V0 of the power supply relay 45. The smoothing capacitor 51 stabilizes the voltage applied to the driver circuit 43.

### PRIOR ART REFERENCE

Patent Document 1: Japanese Laid-Open Patent Publication No. 2007-276706

### SUMMARY OF THE INVENTION

### Problems That the Invention Is to Solve

Replacement of mechanical relays by semiconductor switching elements such as FETs in power supply breakers of motor controllers for, for example, electric power steering devices is now promoted in order to improve reliability, reduce the size of devices, or decrease costs. However, since a semiconductor switching element includes a parasitic diode, a power supply breaker using such semiconductor switching elements must connect a pair of semiconductor switching elements in series in such a manner that the polarity of the parasitic diode of one of the semiconductor switching elements and the polarity of the parasitic diode of the other semiconductor switching element are in opposite directions. As a result, the above-described conventional method cannot detect a problem in the power supply breaker employing the semiconductor switching elements.

Accordingly, it is an objective of the present invention to provide a motor controller that easily and accurately detects a problem in a power supply breaker using a switching element having a parasitic diode and an electric power steering device having the motor controller.

### Means for Solving the Problem

To achieve the foregoing objective and in accordance with a first aspect of the present invention, a motor controller is provided that includes a driver circuit, a power supply breaker, a problem determining section, a smoothing capacitor, and a voltage detecting section. The driver circuit supplies drive power to a motor based on voltage of a power supply. The power supply breaker is arranged in a power supply line connecting the driver circuit to the power supply, and includes a first switching element and a second switching element each having a parasitic diode. The power supply breaker interrupts the power supply line. The problem determining section determines whether there is a problem in the power supply breaker. The smoothing capacitor is arranged between the driver circuit and the power supply breaker. The voltage detecting section detects output voltage of the first switching element and output voltage of the second switching element. The first switching element is arranged closer to the power supply, and the second switching element is arranged closer to the driver circuit. The first and second switching elements are connected in series in such a manner that the polarity of the parasitic diode of the first switching element and the polarity of the parasitic diode of the second switching element are in opposite directions. The problem determining section performs: a first step for determining whether there is a malfunction caused by a short circuit in the first switching element based on the output voltages of the first and second switching elements that are detected when the first and second switching elements are both off; and a second step, after the first step, for determining whether a malfunction caused by a break has occurred in the first switching element based on the output voltages of the first and second switching elements that are detected when only the first switching element is switched on. When the problem determining section determines, through the first and second steps, that the first switching element is free from both a malfunction caused by a short circuit and a malfunction caused by a break, the problem determining section determines whether a malfunction caused by a short circuit or a malfunction caused by a break has occurred in the second switching element by comparing the output voltage of the first switching element and a charge voltage of the smoothing capacitor that are detected afterwards.

In a preferred embodiment, when determining whether a malfunction caused by a short circuit has occurred in the second switching element, the problem determining section determines that the second switching element has a malfunction caused by a short circuit if the output voltage of the first switching element detected when the first and second switching elements are both off is equal to the charge voltage of the smoothing capacitor.

In a preferred embodiment, when determining whether a malfunction caused by a break has occurred in the second switching element, the problem determining section determines that the second switching element has a malfunction caused by a break if the output voltage of the first switching element detected when the first switching element is switched off and the second switching element is switched on is not equal to the charge voltage of the smoothing capacitor.

In accordance with a second aspect of the present invention, an electric power steering device is provided that includes the motor controller according to the first aspect described above.

### BRIEF DESCRIPTION OF THE DRAWINGS

Fig. 1 is a schematic view illustrating an electric power steering (EPS) device according to one embodiment of the present invention;
Fig. 2 is a block diagram representing the electric configuration of the EPS device illustrated in Fig. 1;
Fig. 3 is a diagram for explanatory illustration of steps of a problem detection procedure for a switching element in the EPS device illustrated in Fig. 1;
Fig. 4 is a schematic view illustrating a conventional motor controller; and
Fig. 5 is a diagram for explanatory illustration of steps of a problem detection procedure for a power supply relay in the motor controller illustrated in Fig. 4.

### MODES FOR CARRYING OUT THE INVENTION

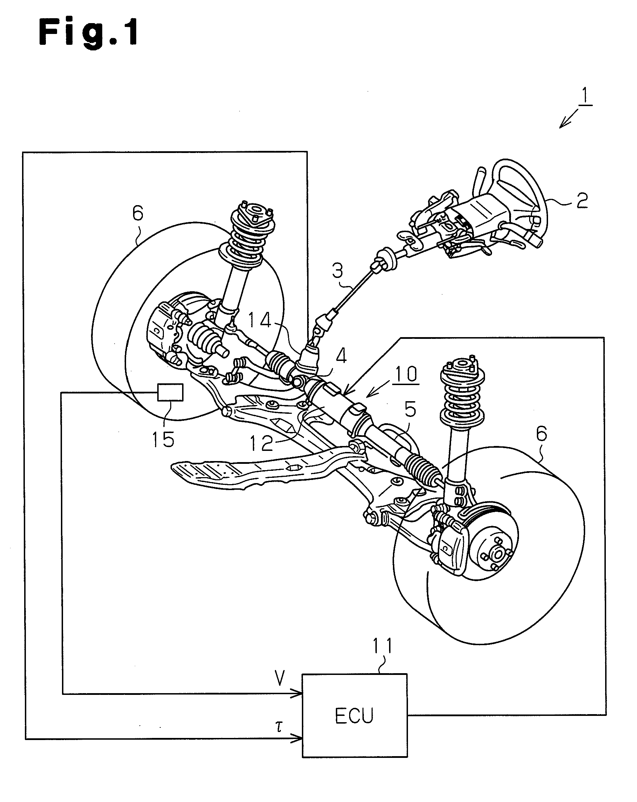

One embodiment of the present invention will now be described with reference to Figs. 1 to 3.

As illustrated in Fig. 1, in a vehicle having an electric power steering (EPS) device 1 according to the present embodiment, a steering shaft 3 extending from a steering wheel 2 is connected to a rack 5 through a rack and pinion mechanism 4. As the driver manipulates the steering wheel 2, the steering shaft 3 rotates. Rotation of the steering shaft 3 is converted into linear reciprocation of the rack 5 through the rack and pinion mechanism 4 and thereby changes the steering angle of steerable wheels 6.

The EPS device 1 includes an EPS actuator 10 and an ECU 11. The EPS actuator 10 serves as a steering force assist device that applies assist force to the steering system of the vehicle to assist in manipulation of the steering wheel 2 by the driver. The ECU 11 serves as control means (a control section) that controls operation of the EPS actuator 10.

The EPS actuator 10 is a rack type EPS actuator in which a motor 12, which is a drive source of the EPS actuator 10, is arranged coaxially with the rack 5. Assist torque generated by the motor 12 is transmitted to the rack 5 through a ball screw mechanism (not shown). The motor 12 is a brushless motor and rotated by power having three phases, which are a U-phase, a V-phase, and a W-phase, supplied by the ECU 11. The ECU 11 controls the assist torque produced by the motor 12 and thus applies an appropriate level of assist force to the steering system (power assist control). In other words, the ECU 11 functions as a motor controller.

A torque sensor 14 and a vehicle speed sensor 15 are connected to the ECU 11. The ECU 11 controls the operation of the EPS actuator 10 and carries out the power assist control based on the steering torque T and the vehicle speed V, which are detected by the torque sensor 14 and the vehicle speed sensor 15, respectively.

The electric configuration of the EPS device 1 will hereafter be described.

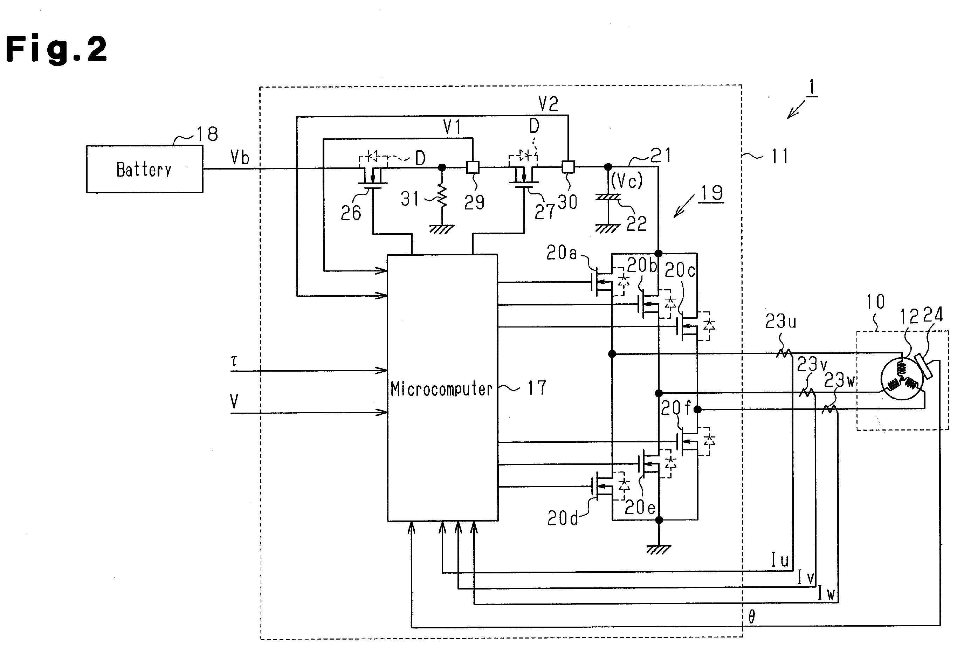

With reference to Fig. 2, which is a block diagram representing the electric configuration of the EPS device 1, the ECU 11 has a microcomputer 17 and a driver circuit 19. The microcomputer 17 serves as a motor control signal output section (motor control signal output means), which outputs a motor control signal. The driver circuit 19 supplies three-phase drive power to the motor 12 in response to the motor control signal output by the microcomputer 17. The driver circuit 19 is arranged in a power supply path from a battery 18, which is a DC power source, to the motor 12.

The driver circuit 19 is configured by a known PWM inverter having a plurality of semiconductor switching elements (power MOSFETs). The semiconductor switching elements include a pair of an FET 20a and an FET 20d that are connected in series, a pair of an FET 20b and an FET 20e that are connected in series, and a pair of an FET 20c and an FET 20f that are connected in series. The pair of FETs 20a, 20d, the pair of FETs 20b, 20e, and the pair of FETs 20c, 20f are connected in parallel. The driver circuit 19 and the battery 18 are connected to each other through a power supply line 21. A smoothing capacitor 22, which stabilizes the voltage supplied to the driver circuit 19, is arranged in the power supply line 21.

Electric current sensors 23u, 23v, 23w and a rotating angle sensor 24 are connected to the ECU 11. The electric current sensors 23u, 23v, and 23w detect electric phase currents lu, lv, and lw, respectively, which are supplied to the motor 12. The rotating angle sensor 24 detects the rotation angle θ of the motor 12. The microcomputer 17 outputs a motor control signal to the driver circuit 19 based on the electric phase currents lu, lv, lw and the rotation angle θ of the motor 12, the aforementioned steering torque T, and vehicle speed V.

The FETs 20a to 20f are each selectively turned on and off in response to the motor control signal output by the microcomputer 17. In this manner, the DC power of the battery 18 is converted into three-phase drive power and fed to the motor 12.

Two switching elements, which are a first FET 26 and a second FET 27, are arranged in the power supply line 21 connecting the battery 18 to the driver circuit 19. The first FET 26 and the second FET 27 are connected in series in such a manner that the polarity of a parasitic diode D of the first FET 26 and the polarity of a parasitic diode D of the second FET 27 are in opposite directions. More specifically, the first FET 26 and the second FET 27 are connected in series with the source terminals of the first and second FETs 26, 27 connected to each other in a portion of the power supply line 21 closer to the battery 18 than the smoothing capacitor 22, which is at the input side of the smoothing capacitor 22. The gate terminals of the first FET 26 and the second FET 27 receive control signals output by the microcomputer 17. Accordingly, operation of the first FET 26 and operation of the second FET 27, or, in other words, the switching state of the first FET 26 and the switching state of the second FET 27, are controlled by the microcomputer 17 independently from each other. In the present embodiment, the first FET 26 and the second FET 27 (and the microcomputer 17) configure a power supply breaker (power supply breaking means) that interrupts the power supply line 21.

Problem determination in the power supply breaker is carried out in the manner described below.

With reference to Fig. 2, a first voltage sensor 29 and a second voltage sensor 30 are arranged at the output side of the first FET 26 and the output side of the second FET 27, respectively, which are arranged in the power supply line 21. The microcomputer 17 detects the output voltage V1 of the first FET 26 based on an output signal from the first voltage sensor 29 and the output voltage V2 of the second FET 27 based on an output signal from the second voltage sensor 30. In the present embodiment, the first and second voltage sensors 29, 30 and the microcomputer 17 configure a voltage detecting section (voltage detection means). A pull-down resistor 31 is arranged between the first FET 26 and the first voltage sensor 29.

As has been described, the microcomputer 17 controls the switching state of the first FET 26 and the switching state of the second FET 27 independently from each other. Further, the microcomputer 17 detects and determines a problem in the power supply breaker, which are problems in the first FET 26 and the second FET 27, based on combinations of the switching states of the first and second FETs 26, 27 and the output voltages V1, V2. That is, the microcomputer 17 functions as a problem determining section (problem determination means).

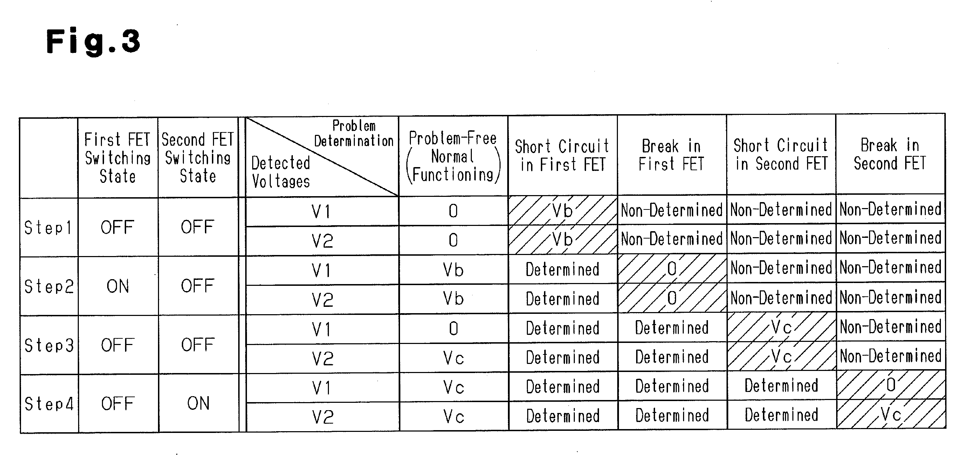

More specifically, the microcomputer 17 detects and determines a problem in the power supply breaker using the procedure shown in Fig. 3, instead of the conventional problem determination method. When a problem, or, in other words, a malfunction, is detected in either one of the first FET 26 and the second FET 27, the EPS device 1 immediately stops operation of the motor 12 in order to ensure safety from failure. Accordingly, the microcomputer 17 sequentially executes the first, second, third, and fourth steps described below unless a problem is discovered in any one of the steps. That is, if a problem is detected in any of the steps, the subsequent steps are not carried out.

### First Step

When the power supply of the vehicle is turned on (the ignition switch is activated), the microcomputer 17 performs a first step of problem determination, or, specifically, determines whether there is a malfunction of the first FET 26 caused by a short circuit based on the output voltages V1, V2 of the first and second FETs 26, 27 that are detected when the switching states of the FETs 26, 27 are both off.

As long as the switching state of the first FET 26 is off, no electric current flows from the battery 18 to the driver circuit 19 via the first FET 26 unless a malfunction is caused by a short circuit in the first FET 26. In other words, considering the fact that the pull-down resistor 31 is arranged in the vicinity of the first voltage sensor 29 and that the smoothing capacitor 22 is not electrically charged yet at the time immediately after the ignition switch is turned on, which is when the problem determination is started, it is assumed that the output voltages V1, V2 of the first and second FETs 26, 27 are both equal to the ground voltage (0V). Accordingly, if the output voltages V1, V2 of the first and second FETs 26, 27 are equal to the power supply voltage Vb of the battery 18, inconsistent with the assumption, the microcomputer 17 determines that a malfunction has been caused by a short circuit in the first FET 26. The output voltage V2 of the second FET 27 being equalized to the power supply voltage Vb at the time when there is a malfunction by a short circuit in the first FET 26 is attributed to the existence of the parasitic diode D of the second FET 27.

### Second Step

Subsequently, in a second step, the microcomputer 17 determines whether a malfunction caused by a break has occurred in the first FET 26 based on the output voltages V1, V2 of the first and second FETs 26, 27 that are detected when only the first FET 26 is switched on.

As long as the switching state of the first FET 26 is on, it is assumed that an electric current is permitted to flow from the battery 18 to the second FET 27 via the first FET 26 and then to the driver circuit 19 via the parasitic diode D of the second FET 27 unless there is a malfunction caused by a break in the first FET 26. Accordingly, when the output voltages V1, V2 of the first and second FETs 26, 27 are unequal to the power supply voltage Vb of the battery 18, inconsistent with the assumption, the microcomputer 17 determines that a malfunction has been caused by a break in the first FET 26.

### Third Step

Next, in a third step, the microcomputer 17 determines whether a malfunction caused by a short circuit has occurred in the second FET 27 based on the output voltage V1 of the first FET 26 that is detected when the first FET 26 is switched back to an OFF state.

The microcomputer 17 performs the third step only when the first FET 26 is free from both the malfunction caused by a short circuit and the malfunction caused by a break. As the first FET 26 is switched on in the above-describe second step, the smoothing capacitor 22 is supplied with the power and thus electrically charged. In this state, if the switching state of the second FET 27 is off, the first FET 26 and the smoothing capacitor 22 are not electrically connected to each other unless there is a malfunction caused by a short circuit in the second FET 27. In other words, it is assumed that the output voltage V1 of the first FET 26 is equal to the ground voltage (0V) and that the output voltage V2 of the second FET 27 is equal to the charge voltage Vc of the smoothing capacitor. Accordingly, if the output voltage V1 of the first FET 26 is equal to the charge voltage Vc of the smoothing capacitor 22, inconsistent with the assumption, the microcomputer 17 determines that the first FET 26 and the smoothing capacitor 22 are electrically connected to each other, or, in other words, a malfunction has been caused by a break in the second FET 27.

### Fourth Step

Then, in a fourth step, the microcomputer 17 determines whether a malfunction caused by a break has occurred in the second FET 27 based on the output voltage V1 of the first FET 26 that is detected when only the second FET 27 is switched on.

As long as the second FET 27 is on and thus the first FET 26 and the smoothing capacitor 22 are electrically connected to each other, it is assumed that the output voltage V1 of the first FET 26 is equal to the charge voltage Vc of the smoothing capacitor 22. Accordingly, if the output voltage V1 of the first FET 26 is unequal to the charge voltage Vc of the smoothing capacitor 22, inconsistent with the assumption, the microcomputer 17 determines that the first FET 26 and the smoothing capacitor 22 are not electrically connected to each other, or, in other words, there is a malfunction caused by a break in the second FET 27.

As a result, the present embodiment ensures simple and reliable detection of a problem in the power supply breaker, that is, problems in the first FET 26 and the second FET 27, which are, more specifically, malfunctions caused by a short circuit or a break in the first and second FETs 26, 27.

The above described embodiment may be modified as follows.

In the present embodiment, the microcomputer 17 determines whether a malfunction caused by a break has occurred in the second FET 27 after determining whether there is a malfunction caused by a short circuit in the second FET 27. However, the present invention is not restricted to this and the microcomputer 17 may determine whether the second FET 27 has a malfunction caused by a short circuit after determining whether there is a malfunction caused by a break in the second FET 27.

The first FET 26 and the second FET 27 may be configured by other switching elements having parasitic diodes other than power MOSFETs.

Although the microcomputer 17 functions as a problem determining section in the illustrated embodiment, a component other than the microcomputer 17 may function as the problem determining section.

The present invention is not restricted to the ECU 11 of the EPS device 1 and may be used in a motor controller employed for use other than an EPS device.

## Claims

1. A motor controller **characterized by** comprising:
a driver circuit supplying drive power to a motor based on voltage of a power supply;
a power supply breaker arranged in a power supply line connecting the driver circuit to the power supply, the power supply breaker including a first switching element and a second switching element each having a parasitic diode, the power supply breaker interrupting the power supply line;
a problem determining section for determining whether there is a problem in the power supply breaker;
a smoothing capacitor arranged between the driver circuit and the power supply breaker; and
a voltage detecting section for detecting output voltage of the first switching element and output voltage of the second switching element,
wherein the first switching element is arranged closer to the power supply, and the second switching element is arranged closer to the driver circuit, the first and second switching elements being connected in series in such a manner that the polarity of the parasitic diode of the first switching element and the polarity of the parasitic diode of the second switching element are in opposite directions,
wherein the problem determining section performs:
a first step for determining whether there is a malfunction caused by a short circuit in the first switching element based on the output voltages of the first and second switching elements that are detected when the first and second switching elements are both off; and
a second step, after the first step, for determining whether a malfunction caused by a break has occurred in the first switching element based on the output voltages of the first and second switching elements that are detected when only the first switching element is switched on, and
wherein, when the problem determining section determines, through the first and second steps, that the first switching element is free from both a malfunction caused by a short circuit and a malfunction caused by a break, the problem determining section determines whether a malfunction caused by a short circuit or a malfunction caused by a break has occurred in the second switching element by comparing the output voltage of the first switching element and a charge voltage of the smoothing capacitor that are detected afterwards.

2. The motor controller according to claim 1, wherein, when determining whether a malfunction caused by a short circuit has occurred in the second switching element, the problem determining section determines that the second switching element has a malfunction caused by a short circuit if the output voltage of the first switching element detected when the first and second switching elements are both off is equal to the charge voltage of the smoothing capacitor.

3. The motor controller according to claim 1 or 2, wherein, when determining whether a malfunction caused by a break has occurred in the second switching element, the problem determining section determines that the second switching element has a malfunction caused by a break if the output voltage of the first switching element detected when the first switching element is switched off and the second switching element is switched on is not equal to the charge voltage of the smoothing capacitor.

4. An electric power steering device **characterized by** comprising the motor controller according to any one of claims 1 to 3.
